Europäisches Patentamt

European Patent Office

Office européen des brevets

(19)

(11) EP 0 482 965 B1

(12) **FASCICULE DE BREVET EUROPEEN**

(45) Date de publication et mention
de la délivrance du brevet:
**20.03.1996 Bulletin 1996/12**

(51) Int Cl.6: **G06F 11/00, B60R 16/02**

(21) Numéro de dépôt: **91402462.5**

(22) Date de dépôt: **17.09.1991**

(54) **Procédé et dispositif d'essai d'un module de traitement de données et leur application en électronique automobile**

Verfahren und Vorrichtung zum Testen eines Datenverarbeitungsmoduls und ihre Anwendung in der Fahrzeugelektronik

Method and device for testing a dataprocessing module and its application in vehicle electronics

(84) Etats contractants désignés:
**DE ES GB**

(30) Priorité: **24.10.1990 FR 9013170**

(43) Date de publication de la demande:
**29.04.1992 Bulletin 1992/18**

(73) Titulaire: **REGIE NATIONALE DES USINES RENAULT S.A.**
**F-92109 Boulogne Billancourt Cédex (FR)**

(72) Inventeurs:
• **Millereau, Jean Luc**
**F-78400 Chatou (FR)**
• **Lenoir, Dominique**
**F-92360 Meudon la Foret (FR)**

(74) Mandataire: **Ernst-Schonberg, Michel et al**
**REGIE NATIONALE DES USINES RENAULT**
**Service 02 67**
**8-10, Avenue Emile Zola**
**F-92109 Boulogne-Billancourt (FR)**

(56) Documents cités:
**EP-A- 0 295 897**

• **IBM TECHNICAL DISCLOSURE BULLETIN. vol. 29, no. 2, Juillet 1986, NEW YORK US pages 539 - 541; 'Programmable error injection with interface line selection'**
• **ELEKTROTECHNIK UND INFORMATIONSTECHNIK. vol. 107, no. 1, Janvier 1990,**
• **WIEN AT pages 30 - 34; G. ZANDRA: 'Datenkommunikation in Kraftfahrzeugen'**

## Description

La présente invention est relative à un procédé et à un dispositif d'essai d'un module électronique de traitement de données conçu pour fonctionner en réception "dégradée" de données, ce module étant connecté à un bus bifilaire assurant une transmission de données numériques par tension différentielle entre les fils. Plus particulièrement, la présente invention est relative à un tel procédé et un tel dispositif trouvant application dans un ensemble de modules multiplexés commandant diverses fonctions dans un véhicule automobile.

Un développement actuel important de l'électronique automobile tient dans l'étude du remplacement du câblage électrique classique par un bus d'alimentation électrique et par un bus de transmission de données interconnectant des modules électroniques de commande d'actionneurs ou d'acquisition de signaux reçus de capteurs. L'avant-projet de norme française R13-708 correspondant au document de travail référencé ISO/TC22/SC3/WG1 publié par l'International Standardization Organization, définit l'architecture générale d'un réseau de communication dit "VAN" embarqué dans un véhicule automobile.

Des structures matérielles de modules électroniques conçus pour faire partie d'un tel réseau sont décrites notamment dans les demandes de brevet français No 8914770, No 90 00912, No 90 02570 et 90 02571. En référence à la figure 1 du dessin annexé où l'on a représenté la structure d'une interface de communication entre un bus de données et la partie "application" d'un tel module, il apparaît que cette interface comprend un filtre, un émetteur/récepteur différentiel de ligne, un dispositif d'analyse de défaillances et un contrôleur de protocole.

Le bus est bifilaire et transmet des signaux analogiques différentiels constitués par une tension signée entre les fils référencés DATA et $\overline{DATA}$, suivant la terminologie de l'avant-projet de norme précitée, le signe de la tension étant représentatif d'un état logique binaire.

Le filtre empêche la transmission vers le récepteur de ligne de signaux électriques induits par des perturbations électromagnétiques engendrées par divers équipements présents dans un véhicule automobile (bobine d'allumage en particulier) et susceptibles de fausser les informations à transmettre.

La partie émettrice de l'émetteur/récepteur de ligne assure la conversion des données émises (DE) entrant par une ligne unipolaire, en signaux différentiels de tension adaptés au bus (DATA, $\overline{DATA}$). On notera qu'en fonctionnement normal chacune des lignes DATA et $\overline{DATA}$ se trouve à chaque instant dans un état électrique représentatif de l'état logique complémentaire de l'état logique affiché par l'autre ligne.

La partie réceptrice de l'émetteur/récepteur de ligne comprend, comme décrit dans la demande de brevet français No. 89 14770 précitée du 10 novembre 1989, trois comparateurs et une source de tension de polarisation, les trois comparateurs fournissant respectivement des signaux ERR1, ERR2 et RO qui sont délivrés à un dispositif d'analyse de défaillances du bus conçu pour détecter, à partir de ces trois signaux, une défaillance d'un des fils du bus (coupure du fil ou court-circuit) et pour délivrer cependant des données reçues correctes (DR) à un contrôleur de protocole de transmission, ces données étant établies à partir des états électriques de l'autre fil. En somme dans un tel bus bifilaire différentiel, une des deux lignes "double" l'autre, en cas de défaillance.

Dans les véhicules automobiles ces défaillances sont le plus souvent fugitives car dues à des vibrations génératrices de faux contacts qui disparaissent avec ces vibrations. L'interface d'analyse des défaillances décrit dans la demande de brevet français No. 89 14770 précitée rétablit automatiquement la communication par la sortie normale RO quand la cause de la défaillance a disparu.

Le contrôleur de protocole vérifie la nature des informations DR provenant du dispositif d'analyse de défaillances, s'assure que les messages reçus respectent le protocole défini (par exemple celui du projet de norme VAN), gère les priorités, vérifie que les messages émis vers un autre module arrivent à destination, sérialise et met en forme suivant le protocole les informations (DE) à émettre, désérialise les informations reçues (DR) en vue de leur exploitation dans l'application. Cette application consiste en une commande d'un actionneur ou d'un capteur, commande associée à des échanges d'informations bidirectionnels avec ceux-ci.

Un ensemble multiplexé comprend classiquement plusieurs modules électroniques tels que celui décrit ci-dessus, interconnectés entre eux et avec une ou plusieurs unités centrales de traitement, par l'intermédiaire du bus bifilaire. Chaque module commande ainsi une ou plusieurs applications regroupées localement dans le véhicule (commande de feux, de planche de bord, etc...).

Il est clair que le bon fonctionnement des applications est conditionné par la correction des informations (DR) éventuellement reconstituées et transmises par le dispositif d'analyse de défaillances, au contrôleur de protocole et à l'application.

C'est le but de la présente invention que de fournir un procédé et un dispositif permettant d'exécuter des essais du module électronique en vue de vérifier sa capacité à fonctionner correctement en cas de défaillance d'un des fils c'est-à-dire, dans le vocabulaire de la technique, à tester son fonctionnement en mode "dégradé".

On atteint ce but de la présente invention, ainsi que d'autres qui apparaîtront à la lecture de présente description, avec un procédé d'essai d'un module électronique de traitement de données conçu pour fonctionner en réception dégradée de données, ce module étant connecté à un bus bifilaire assurant une transmission de données numériques par tension différentielle entre les fils. Suivant l'invention, on bloque toute modulation de la tension sur un premier fil du bus, on interroge le module par des données émises sur le bus et comprises par le module grâce à la modulation de l'activité électrique perçue sur le deuxième fil du bus, on répète ces opérations en bloquant la tension sur le deuxième fil et on analyse les réponses du module aux interrogations émises'pour diagnostiquer l'état de fonctionnement du module en réception dégradée.

On provoque ainsi artificiellement un défaut sur un fil du bus pour tester la capacité des moyens incorporés au bus pour assurer son bon fonctionnement en réception dégradée, à reconstituer correctement les données transmises au module par le bus. On teste du même coup la capacité de l'ensemble constitué par ces moyens, le contrôleur de protocole et l'application, à fonctionner correctement.

Suivant une autre caractéristique du procédé selon l'invention, appliquée à un module formant partie d'un ensemble de modules interconnectés par le bus bifilaire et accédant à ce bus par une procédure maître-esclave à priorité accordée aux modules imposant un état électrique dominant sur le bus, on bloque la modulation de la tension sur un fil du bus pendant l'essai du module en imposant sur celui-ci la tension correspondant à l'état électrique dominant.

Pour la mise en oeuvre de ce procédé, l'invention fournit un dispositif comprenant a) des première et deuxième sources de tension fixes propres à bloquer toute modulation de tension sur les premier et deuxième fils du bus, respectivement, b) un circuit de commande pour connecter sélectivement et successivement ces première et deuxième sources aux premier et deuxième fils et c) des moyens de traitement d'informations pour émettre sur la ligne non bloquée du bus des informations d'interrogations du module et pour analyser les réponses du module à ces interrogations, de manière à diagnostiquer l'état de fonctionnement du module en réception dégradée.

D'autres caractéristiques et avantages de la présente invention apparaîtront à la lecture de la description qui va suivre et à l'examen du dessin annexé dans lequel :

- la figure 1 est un diagramme fonctionnel de l'interface de communication de module électronique décrit en préambule de la présente description, et du dispositif d'essai suivant l'invention, associé à cette interface, et
- la figure 2 illustre une partie d'un mode de réalisation du dispositif schématisé à la figure 1.

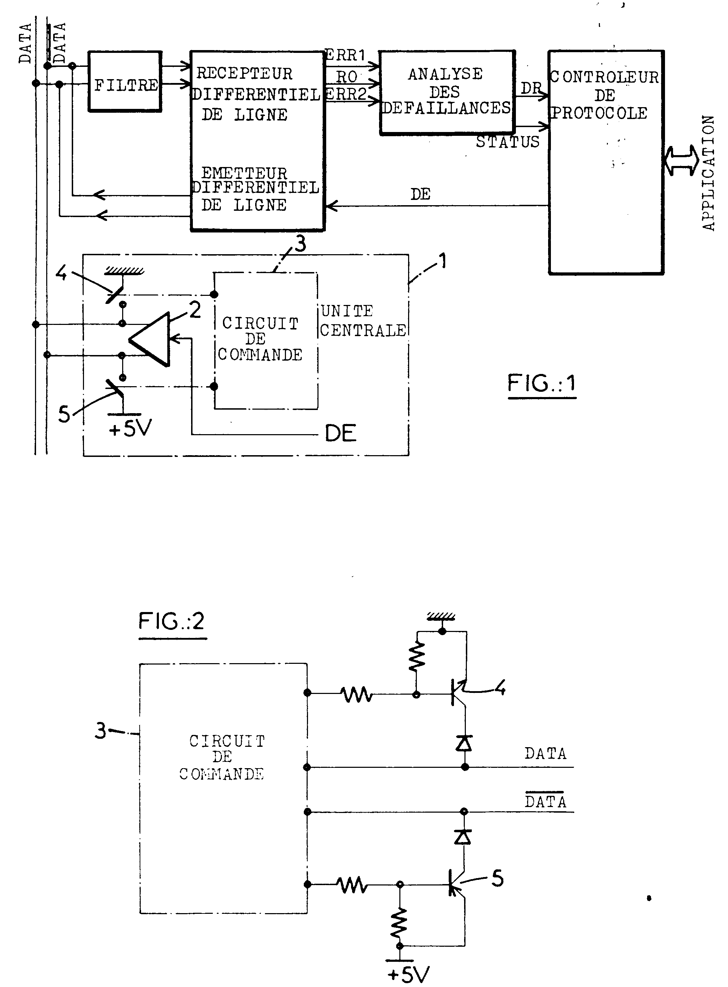

Comme on l'a vu plus haut, l'interface de communication représentée à la figure 1, fait partie d'un module électronique de traitement de données constituant un des éléments d'un ensemble de tels modules, architecturé conformément aux spécifications de l'avant-projet de norme "VAN" précitée, sans que cette précision présente un caractère limitatif quant à la portée de l'invention. De tels modules communiquent entre eux et avec une unité centrale de traitement 1 grâce au bus bifilaire (DATA, $\overline{\text{DATA}}$). L'architecture VAN fonctionne, en matière d'accès des modules au bus, suivant une procédure multimaître dans laquelle la détection d'interférences sur le bus (ou collision ) s'appuie sur l'utilisation de deux types d'état du bus appelés état dominant et état récessif.

Lors d'une transmission simultanée de plusieurs états dominants et récessifs, l'état résultant sur le bus est dominant. Dès qu'un module émetteur détecte une interférence par le fait que l'état sur le bus est différent de l'état transmis, il cesse immédiatement son émission. La priorité est ainsi accordée aux modules qui émettent un état dominant sur ceux qui émettent un état récessif.

A titre d'exemple non limitatif, c'est ainsi qu'un état "dominant" peut être transmis sur le bus en portant les fils DATA, $\overline{\text{DATA}}$ aux tensions 0 et + 5 volts respectivement, alors que l'inversion de ces tensions correspond à un état "récessif".

Suivant l'invention, on peut alors bloquer artificiellement une ligne du bus pour simuler un défaut de cette ligne (coupure ou court-circuit à la masse ou à la borne positive d'une source d'énergie électrique constituée par la batterie du véhicule) en portant cette ligne à l'état électrique qui est le sien lors de la transmission d'un bit dominant.

C'est ainsi que pour bloquer sélectivement la transmission d'informations par le fil DATA, on porte ce fil à une tension de 0 volt par connexion à une masse électrique, alors que pour bloquer une telle transmission sur le fil $\overline{\text{DATA}}$, on connecte ce fil à une source de tension à + 5 volts.

L'unité centrale 1 est munie, comme tous les autres modules connectés au bus, d'un émetteur/récepteur de ligne dont on a représenté la partie émettrice 2 sur la figure 1.

L'unité centrale comprend aussi un circuit 3 pour commander séparément et successivement la connexion des fils DATA, $\overline{\text{DATA}}$ du bus à la masse ou à une source de tension à + 5 volts respectivement, lors de l'exécution du procédé d'essai d'un module électronique suivant l'invention, tel que décrit dans la suite. A cet effet le circuit 3 commande des interrupteurs 4, 5 qui sont ouverts au repos et qui contrôlent la connexion aux fils DATA, $\overline{\text{DATA}}$ d'une masse et d'une source à + 5 volts, respectivement.

Le procédé d'essai selon l'invention se développe alors comme suit. On teste d'abord, par exemple, le fil DATA en bloquant toute transmission sur le fil $\overline{\text{DATA}}$ par commande de la fermeture de l'interrupteur 5. La tension + 5 volts alors établie et maintenue sur $\overline{\text{DATA}}$ correspond à l'état électrique de ce fil lors de la transmission d'un bit dominant : aucun des autres modules interconnectés sur le bus ne pourra alors obtenir la maîtrise du bus et aucune modulation de la tension sur $\overline{\text{DATA}}$ n'est alors possible.

On simule ainsi une coupure ou un court-circuit affectant le fil $\overline{\text{DATA}}$, défaut qui doit être perçu et corrigé par le dispositif d'analyse de défaillances alimenté par les signaux ERR1, ERR2, et RO (voir le préambule de la présente description) si ce dispositif fonctionne correctement, en combinaison avec le contrôleur de protocole et l'application. C'est un défaut éventuel de fonctionnement de cet ensemble que l'invention vise à détecter.

Pour tester ce fonctionnement, l'unité centrale émet des instructions d'interrogation du module par l'intermédiaire de son propre émetteur de ligne 2, informations qui sont alors perçues par le récepteur différentiel de ligne du module grâce à la ligne DATA, après filtrage. Si le dispositif d'analyse de défauts fonctionne correctement, il transmet exactement sur sa sortie DR (données reçues) unipolaire les instructions d'interrogations reçues. Celles-ci sont contrôlées par le contrôleur de protocole et reçues par l'application qui répond à l'adresse de l'unité centrale. La réponse est contrôlée dans l'unité centrale et un diagnostic concernant l'état de fonctionnement, bon ou défectueux, du module est alors établi à partir de ce contrôle.

On remarquera que le dispositif d'analyse de défaillances du module comprend une sortie STATUS connectée au contrôleur de protocole. Lors d'un court-circuit entre les deux fils du bus, la communication est totalement bloquée, sans possibilité de correction par l'analyseur de défaillances et la ligne STATUS informe le contrôleur de protocole de cette situation.

On teste le fil $\overline{DATA}$ suivant la procédure décrite ci-dessus pour le fil DATA, à ceci près que l'unité centrale bloque alors toute communication sur DATA en commandant, par l'intermédiaire du circuit 3, la fermeture de l'interrupteur 4.

Les deux essais ayant été exécutés, l'unité centrale établit un diagnostic global quant au fonctionnement de l'ensemble analyseur de défaillances/contrôleur de protocole/application que l'on peut attendre, bon ou défectueux, en cas de court-circuit ou de coupure réelle d'un des fils du bus. On sait que de tels contrôles sont essentiels s'agissant notamment du fonctionnement d'organes faisant partie d'un véhicule automobile et dont des défauts éventuels sont susceptibles notamment de mettre en danger la sécurité des personnes transportées.

On a représenté à la figure 2 du dessin annexé un mode de réalisation pratique de la commande de connexion d'une masse et d'une source de tension à + 5 volts aux fils DATA et $\overline{DATA}$ respectivement. Les interrupteurs 4 et 5 sont constitués par des transistors de types opposés tels que des transistors NPN et PNP respectivement. Le circuit de commande 3 élabore des signaux de commande de ces transistors par leur base. Des diodes de protection des résistances de charge sont montées classiquement sur les broches des transistors. On comprend qu'une tension nulle sur les bornes de sortie du circuit 3 assure le blocage du fil $\overline{DATA}$ (pour l'essai du fil DATA) alors qu'une tension positive, de + 5 volts par exemple sur ces bornes assure le blocage du fil DATA (pour l'essai du fil $\overline{DATA}$ ).

Dans ce qui précède on a considéré que les moyens de mise en oeuvre du procédé d'essai selon l'invention étaient installés dans une unité centrale de traitement interconnectée par le bus bifilaire avec d'autres modules de traitement d'informations tels que ceux que l'on trouve dans un réseau de communication multiplexé embarqué dans un véhicule automobile. On ne sortirait évidemment pas du cadre de l'invention en installant ces moyens dans un de ces autres modules. De même, l'invention pourrait être mise en oeuvre dans un réseau multiplexé autre que le réseau "VAN" décrit à titre d'exemple.

## Revendications

1. Procédé d'essai d'un module électronique de traitement de données conçu pour fonctionner en réception dégradée de données, ce module formant partie d'un ensemble de modules interconnectés par un bus bifilaire assurant une transmission de données numériques par tension différentielle entre les fils, ces modules accédant à ce bus par une procédure maître-esclave à priorité accordée aux modules imposant un état électrique dominant sur le bus, caractérisé en ce qu'on bloque toute modulation de la tension sur un premier fil du bus, en imposant sur celui-ci la tension correspondant à l'état électrique dominant, on interroge le module par des données émises sur le bus et comprises par le module grâce à la modulation de l'activité électrique perçue sur le deuxième fil, on répète ces opérations en bloquant la tension sur le deuxième fil et on analyse les réponses du module aux interrogations émises pour diagnostiquer l'état de fonctionnement du module en réception dégradée.

2. Dispositif pour la mise en oeuvre du procédé conforme à la revendication 1, caractérisé en ce qu'il comprend a) des première et deuxième sources de tensions fixes propres à bloquer toute modulation de tension sur les premier et deuxième fils du bus, respectivement, (b) un circuit de commande (3) pour connecter sélectivement et successivement ces première et deuxième sources aux premier et deuxième fils et c) des moyens de traitement d'informations (1) pour émettre sur la ligne non bloquée du bus des informations d'interrogation du module et pour analyser les réponses du module à ces interrogations de manière à diagnostiquer l'état de fonctionnement du module en réception dégradée, les première et deuxième tensions délivrées par les première et deuxième sources correspondant à celles qui sont établies par un module-maître sur les premier et deuxième fils du bus pour en prendre le contrôle.

3. Dispositif conforme à la revendication 2, caractérisé en ce que le circuit de commande (3) contrôle des premier (4) et deuxième (5) transistors de types de conductivité opposés dont les circuits collecteur-émetteur raccordent les première et deuxième sources aux premier et deuxième fils du bus respectivement, le circuit de commande (3), les transistors (4, 5) et les sources de tension formant partie du module-maître (1).

4. Dispositif conforme à la revendication 3, caractérisé en ce que le module-maître est une unité centrale de traitement (1) interconnectée par le bus avec tous les autres modules.

5. Application du dispositif conforme à l'une quelconque des revendications 2 à 4, à un réseau local de communications multiplexées entre modules électroniques embarqués dans un véhicule automobile.

**Patentansprüche**

1. Verfahren zum Prüfen eines Datenverarbeitungsmoduls, das ausgelegt ist für eine Funktion bei beeinträchtigtem Empfang von Daten und das Teil einer Anordnung von Modulen ist, die durch einen Doppelleiter-Bus miteinander verbunden sind, der eine Übertragung numerischer Daten durch eine Spannungsdifferenz zwischen den Leitern gewährleistet, wobei die Module Zugang zum Bus haben durch ein Master-Slave-Verfahren, bei dem die Priorität denjenigen Modulen zuerkannt wird, die den Bus mit einem dominierenden elektrischen Zustand beaufschlagen, dadurch gekennzeichnet, daß jegliche Spannungsmodulation in einem ersten Bus-Leiter unterbunden wird, indem dieser mit der dem dominierenden elektrischen Zustand entsprechenden Spannung beaufschlagt wird, daß das Modul abgefragt wird durch dem Bus zugeführte Daten, die vom Modul wahrgenommen werden aufgrund der Modulation der vom zweiten Leiter aufgenommenen elektrischen Aktivität, daß diese Schritte wiederholt werden, wobei die Spannung am zweiten Leiter festgehalten wird, und daß die Antworten des Moduls auf die abgeschickten Abfragen analysiert werden, um den Funktionszustand des Moduls beim beeinträchtigten Empfang zu diagnostizieren.

2. Vorrichtung zur Durchführung des Verfahrens nach Anspruch 1, dadurch gekennzeichnet, daß sie aufweist a) erste und zweite feste Spannungsquellen, die in der Lage sind, jegliche Spannungsmodulation an den ersten bzw. zweiten Bus-Leitern zu unterbinden, b) eine Steuerschaltung (3), um wahlweise und nacheinander die erste und die zweite Quelle mit dem ersten und dem zweiten Leiter zu verbinden und c) eine Informationsverarbeitungsanordnung (1), um die nichtblockierte Bus-Leitung mit Abfrageinformationen des Moduls zu beaufschlagen und um die Antworten des Moduls auf diese Abfragen dergestalt zu analysieren, daß der Betriebszustand des Moduls beim beeinträchtigten Empfang diagnostiziert wird, wobei die erste und die zweite von der ersten und der zweiten Quelle abgegebenen Spannungen denjenigen entsprechen, die von einem Master-Modul zu Prüfzwecken an der ersten und der zweiten Bus-Leitung angelegt werden.

3. Vorrichtung nach Anspruch 2, dadurch gekennzeichnet, daß die Steuerschaltung (3) erste (4) und zweite (5) Transistoren vom entgegengesetzten Leitungstyp steuert, deren Kollektor-Emitter-Schaltkreise die ersten und zweiten Quellen mit den ersten bzw. zweiten Bus-Leitungen verbinden, wobei die Steuerschaltung (3), die Transistoren (4, 5) und die Spannungsquellen Teil des Master-Moduls (1) sind.

4. Vorrichtung nach Anspruch 3, dadurch gekennzeichnet, daß das Master-Modul eine zentrale Verarbeitungseinheit (1) ist, welche über den Bus mit allen anderen Modulen verbunden ist.

5. Anwendung der Vorrichtung nach einem der Ansprüche 2 bis 4, auf ein lokales Multiplex-Konmunikationsnetz zwischen elektronischen Modulen, die in ein Kraftfahrzeug eingebaut sind.

**Claims**

1. A process for testing an electronic data processing module designed to function in a degraded data reception mode, said module forming part of an assembly of modules interconnected by a two-wire bus providing for transmission of digital data by differential voltage between the wires, said modules accessing said bus by a master-slave procedure with priority accorded to the modules imposing a dominant electrical state on the bus, characterised in that all modulation of the voltage on a first wire of the bus is blocked by imposing thereon the voltage corresponding to the dominant electrical state, the module is interrogated by data emitted on the bus and understood by the module by virtue of modulation of the electrical activity perceived on the second wire, said operations are repeated by blocking the voltage on the second wire and the responses of the module to the interrogations emitted are analysed to diagnose the state of functioning of the module in the degraded reception mode.

2. Apparatus for carrying out the process according to claim 1 characterised in that it comprises a) first and second sources of fixed voltages for blocking all voltage modulation on the first and second wires of the bus respectively, (b) a control circuit (3) for selectively and successively connecting said first and second sources to the first and second wires, and (c) data processing means (1) for emitting on the non-blocked line of the bus items of module interrogation information and for analysing the responses of the module to said interrogations so as to diagnose the state of functioning of the module in a degraded reception mode, the first and second voltages delivered by the first and second sources corresponding to those which are established by a master module on the first and second wires of the bus to take control thereof.

3. Apparatus according to claim 2 characterised in that the control circuit (3) controls first (4) and second (5) transistors of opposite conductivity types whose collector-emitter circuits connect the first and second sources to the first and second wires of the bus respectively, the control circuit (3), the transistors (4, 5) and the voltage sources forming part of the master module (1).

4. Apparatus according to claim 3 characterised in that the master module is a central processing unit (1) interconnected to all the other modules by the bus.

5. Application of the apparatus according to any one of claims 2 to 4 to a local network for multiplexed communications between electronic modules installed in a motor vehicle.

FIG.:1

FIG.:2